(19) Europäisches Patentamt
European Patent Office
Office européen des brevets

(11) **EP 1 821 112 A1**

(12) **EUROPEAN PATENT APPLICATION**

(43) Date of publication:
**22.08.2007 Bulletin 2007/34**

(51) Int Cl.:
**G01R 31/36** (2006.01)

(21) Application number: **07003428.5**

(22) Date of filing: **19.02.2007**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **17.02.2006 US 356117**

(71) Applicant: **BPPOWER Inc.
Taipei (TW)**

(72) Inventor: **Huang, Yung-Sheng
M1S 5L6 Toronto (CA)**

(74) Representative: **Müller-Boré & Partner
Patentanwälte
Grafinger Strasse 2
81671 München (DE)**

(54) **Method and apparatus for monitoring the condition of a battery by measuring its internal resistance**

(57) A method comprises coupling a first power transistor as a first external load in series with the battery, coupling a second power transistor as a second external load in series with the battery, conducting each power transistor to supply a transient large current to the battery for sampling a group of sampled reference voltages and sampled load voltages in a very transient sampling time for a plurality of times and thus obtaining an internal resistance of the battery. The internal resistance of the battery can then be compared with a predetermined warning value thereof so as to determine whether the former is equal to or larger than the warning value or not, and issuing a warning through an I/O if the determination is affirmative. The invention enables a driver to correctly know the actual condition of the battery in substantially real time while consuming a minimum amount of power.

FIG3

EP 1 821 112 A1

Description

## BACKGROUND OF THE INVENTION

### 1. Field of the Invention

The present invention relates to monitoring apparatus and more particularly to a method of monitoring the electric power of a battery by measuring the internal resistance of the battery by means of conducting a first power transistor as a first external load to obtain a reference voltage and then conducting second power transistor as second external load to obtain a load voltage and comparing the internal resistance of the battery with a predetermined warning value thereof such that a warning can be displayed if the power is lower than a predetermined level prior to starting the engine. The present invention further particularly relates to such a monitoring apparatus.

### 2. Description of Related Art

It is known that a driver has to start the engine of a motor vehicle before driving it. Also, for successfully starting the engine, there must be sufficient electric power stored in the battery. Typically, a battery has an approximate lifetime. However, factors such as ambient temperature, charging conditions and time, and load discharge all can adversely affect the lifetime of the battery. Thus, there is difference between the practical lifetime and the approximate lifetime of any particular battery and the difference is sometimes very large. Hence, in practice, there is no way for a driver (or even an experienced one) to know the electric power level of the battery prior to starting the engine. Typically, only a motor vehicle repair shop technician is able to know the electric power level by means of a test device. However, the test device is somewhat bulky, thus prohibiting it from being carried by the motor vehicle. It is common that a driver finds the battery to be low only when it fails to start the engine. Alternatively, the battery may be already damaged but the driver is not aware before next start even it is successful in a particular start. This is not desirable and may even be dangerous since the driver may park his/her car in a remote area, mountain, or desert.

Advantageously, a battery power measuring device would be installed in a car as requisite equipment. But power measurement of the battery may also consume the electric power of the battery. Hence, a frequent power measurements is not desirable. Thus, it is specially desirable to accurately measure the electric power of battery in a relatively short period of time by consuming a minimum amount of electric power thereof. The present application is relevant to commonly assigned U.S. Patent Nos. 6,704,629 and 6,791,464 both entitled "Device for Monitoring Motor Vehicle's Electric Power and Method Thereof". The present application is closely relevant to a pending application with a Pub. No. US 2006/0001429 A1. The patent relates to a method and apparatus for monitoring the condition of a battery by measuring its internal resistance at two terminals of the battery by using a floating voltage Vo as its reference voltage to compare with a sampling voltage. However, a value of the floating voltage Vo itself is not stable as it will be affected by intermittently charging on the battery or up and down variation of load at two terminals of the battery or ageing of the battery.

Tsuji patent 6,072,300 relates to characterization of the individual batteries of a large set of batteries. Internal resistance is estimated from cell voltage. See Col. 5, lines 32 - 38.

Fakruddin patent 5,027,294 also characterizes battery condition based on measurements of voltage.

Huang patent 6,704,629, to the present inventor, measures battery condition in part by drawing a substantial current from the battery by connecting a significant load to it for a short period of time, as is part of the method of the present invention, but measures voltage only.

Arai patent 6,201,373 shows a circuit for measuring the state of charge (SOC) of a battery, not a battery condition evaluation device per se. Voltage and current are both sampled.

Hirzel patent 5,381,096 also relates to SOC measurement.

Satake patent 6,531,875 teaches estimating the open circuit voltage of a battery based on extrapolation from a series of measurements.

Disser et al. Pub. No. US 2003/0067221 A1 shows voltage regulator circuitry for automotive use.

Yokoo patent 5,828,218 shows a method for estimating residual capacity of a battery based on discharge current and voltage during discharge.

Munson patent 5,900,734 shows a battery monitoring system wherein the battery voltage is compared to a fixed reference value and an alarm is given when the battery voltage is less than the reference value.

Bramwell patent 6,097,193 discusses various methods of measuring the internal resistance and/or impedance of a battery, including application of a small AC signal to the battery and using a Wheatstone bridge or equivalent to measure the internal resistance. See col. 1, lines 40 - 48. Bramwell's claimed method includes the steps of measuring impedance of a battery by sourcing to or sinking from the battery a current of known magnitude while intervals while the vehicle sits. Col. 9, lines 18 - 50. An alarm message can be given when QV falls below a predetermined point - Col. 11, lines 28 - 39. Gollomp also measuring the terminal voltage, and determining the impedance therefrom.

Turner et al. patent 6,249,106 shows a circuit for preventing discharge of a battery beyond a predetermined point. Yorksie et al. patent 3,852,732 is directed toward the same objective. Finger et al. patent 4,193,026 is directed to measuring the SOC of a battery by integrating a signal indicative of reduction of the terminal voltage below a threshold value.

Reher et al. patent 5,130,699 shows a device for monitoring a battery by measuring the terminal voltage at regular intervals, comparing the measured values to a predetermined value, and setting a flag in a shift register depending on the result. When a predetermined number of flags indicate an under voltage condition an alarm is given.

Sato et al. patent 5,193,067 discloses determining the internal impedance of a battery by measuring the voltage during discharge of a predetermined current, or by measuring the current during discharge at a predetermined voltage.

Slepian patent 5,764,469 shows disconnecting electronic equipment of a vehicle when the battery voltage falls below a predetermined level.

Huang patent 6,791,464, to the present inventor, shows evaluation of the condition of a motor vehicle's battery by monitoring the voltage across the battery during starting, while the starter provides a substantial load. The minimum voltage reached during starting can be compared to predetermined value to evaluate the condition of the battery.

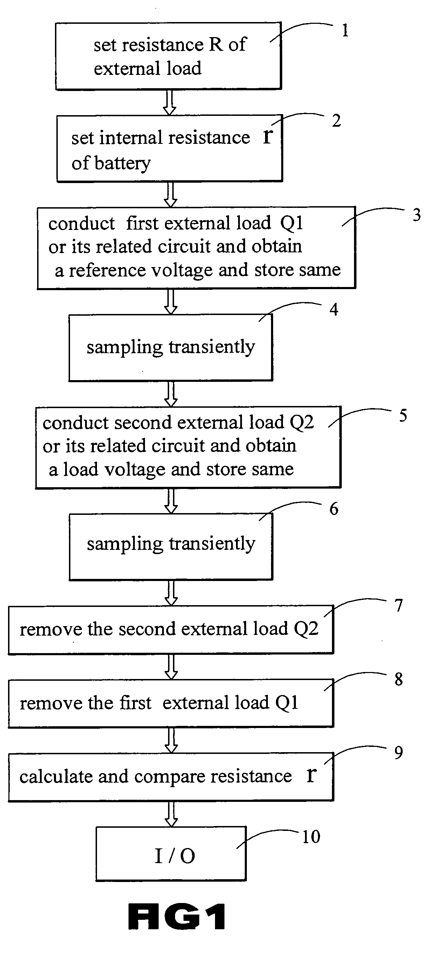

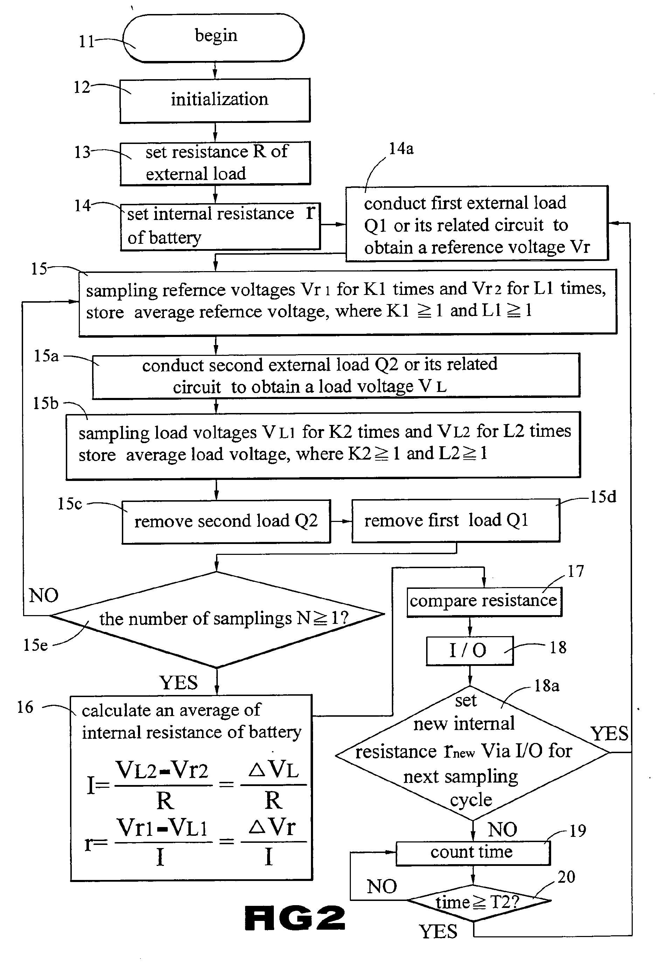

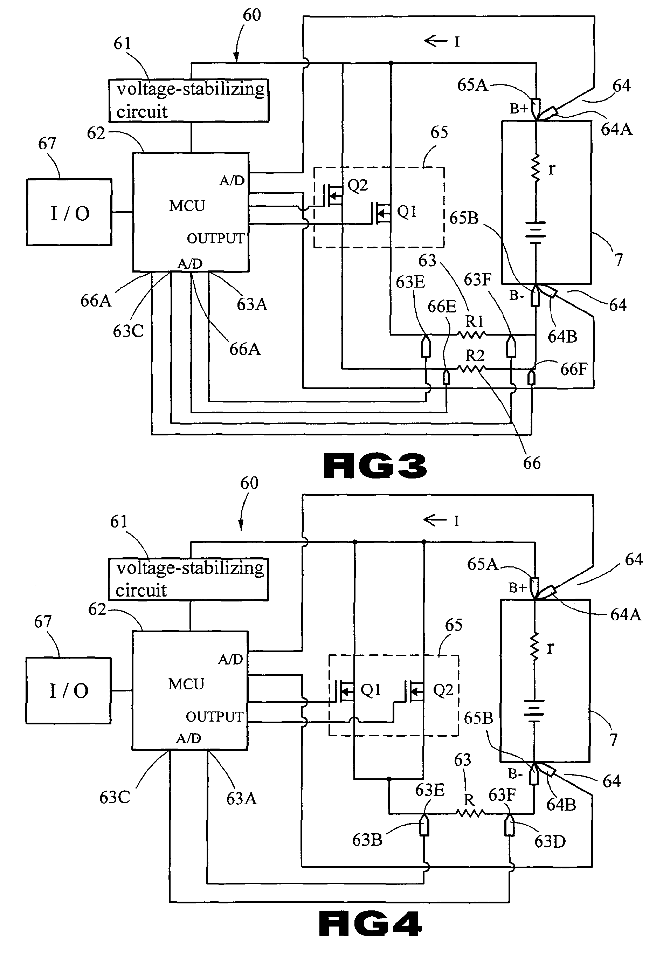

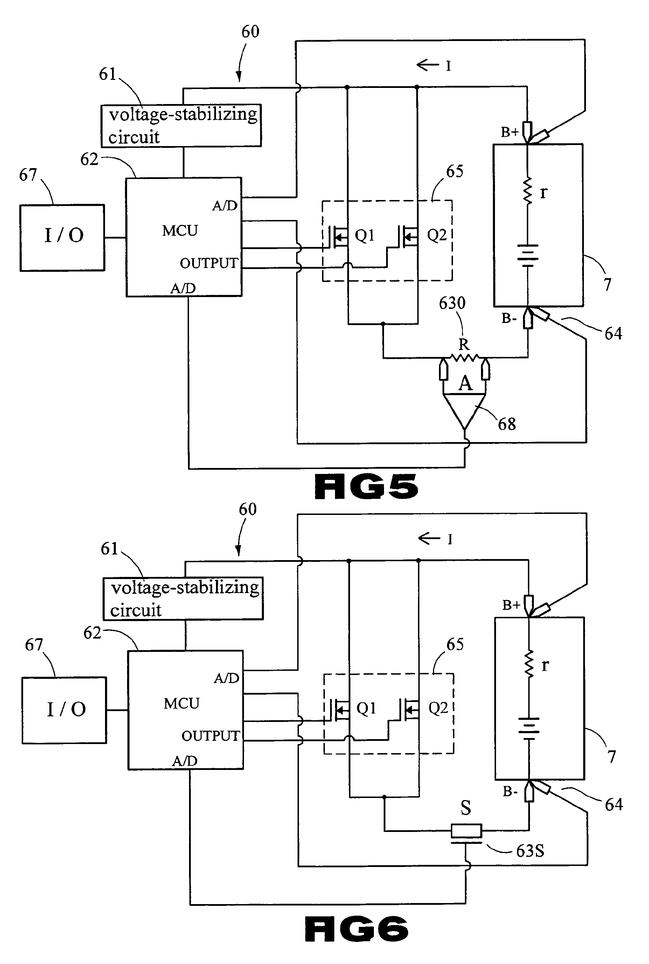

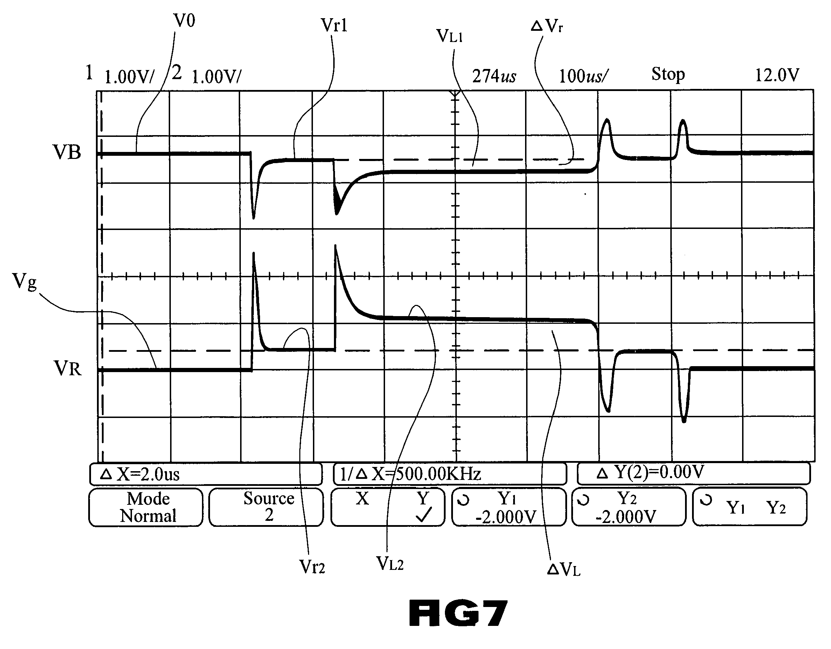

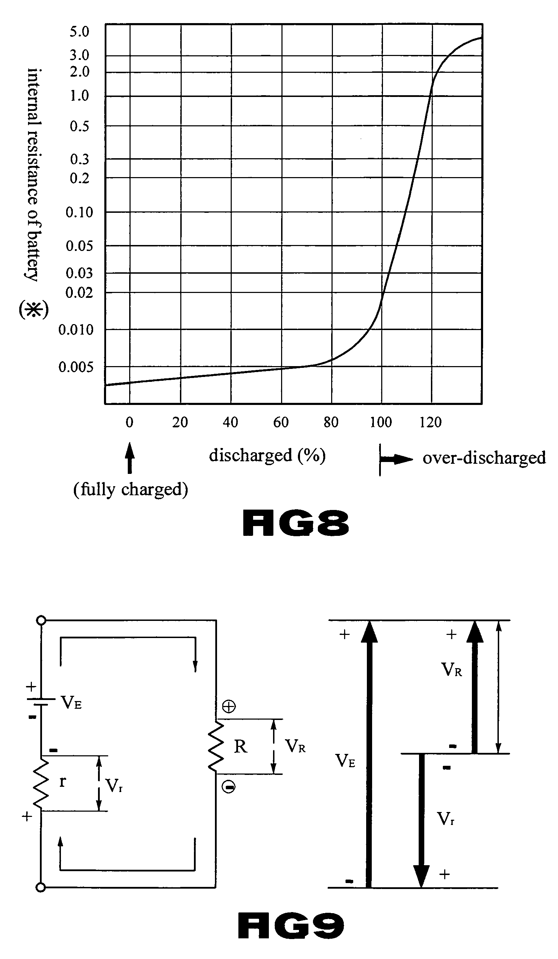

Gollomp et al. patent 6,424,157 refers to the difficulty of measuring battery SOC from open-circuit voltage (OCV) because this requires that everything be disconnected. Gollomp instead teaches monitoring of the quiescent voltage (QV), e.g., measured at 30 minutes intervals while the vehicle sits. Col. 9, lines 18 - 50. An alarm message can be given when QV falls below a predetermined point - Col. 11, lines 28 - 39. Gollomp also teaches monitoring of voltage and current during engine starting. See FIG. 6. This data is stored in memory, see Col. 12, lines 48 - 50, and used to determine dynamic internal resistance (IR) and polarization resistance (PR). Gollomp also teaches monitoring SOC and QV over time to determine when the battery won't be able to start the car; see FIG. 3, Col. 14, line 22 - Col. 16, line 36. Gollomp also teaches storing the first IR value of the battery, or some subsequent one, for "future use" - e.g., determination of IR change over time. PR is similarly monitored over time; see Col. 17, line 12 - Col. 18, line 35. The result is to give warning of incipient battery failure or some problem with connections or the like. These data can be monitored during successive starts - see claim 1.

Kchao patent 5,751,217 shows a method and circuit for assessing battery impedance, which is stated to be applicable only to fully charged batteries, see Col. 3, lines 49 - 55, and Col. 4, line 12, and which is intended to be incorporated in a battery charger. Applicant's device is not limited to fully charged batteries and can be economically provided as a stand-alone unit.

## SUMMARY OF THE INVENTION

It is an object of the present invention to provide an apparatus of long-term monitoring or short time test at two terminals of the battery in a relatively transient sampling time with a transient large current by consuming a minimum amount of electric power thereof such that a warning can be displayed for the driver via an I/O operation if the power is lower than a predetermined level during running of the engine or prior to starting the engine.

It is a further object of the present invention to provide a method of monitoring electric power of a battery, comprising the steps of (1) setting a resistance of an external load based on battery type and an internal resistance of the battery to be measured; (2) setting an internal resistance of the battery to be measured; (3) transiently sampling at two terminals of the battery to be measured with a transient large current supplied from a conducted first power transistor for a plurality of first and second times so as to obtain an average of each group of first and second sampled reference voltages; (4) transiently sampling at two terminals of the battery to be measured with a transient large current supplied from a conducted second power transistor for a plurality of first and second times so as to obtain an average of each group of first and second sampled load voltages; (5) removing the first and second power transistors; (6) dividing a difference between the second sampled load voltage and the second sampled reference voltage by the resistance of the external load to obtain a transient large current of the battery; (7) dividing a difference between the average first sampled reference voltage and the average first sampled load voltage by the transient large current of the battery to obtain the internal resistance of the battery; (8) comparing the obtained internal resistance of the battery to be measured with a predetermined warning value of the internal resistance of the battery so as to determine whether the former is equal to or larger than the predetermined warning value or not; and (9) issuing a warning through an I/O if the determination in step (8) is affirmative. By utilizing this method, it is possible of enabling a driver to know the actual electric power capacity of the battery in substantially real time.

It is another object of the present invention to provide a method of monitoring electric power of a battery, comprising: (1) coupling a first power transistor to two terminals of the battery as a first external load with a transient large current at a very transient sampling time to obtain a reference voltage;

(2) coupling second power transistor to two terminals of the battery as second external load with a transient large current at a very transient sampling time to obtain a load voltage;

(3) calculating the internal resistance of the battery by subtracting the load voltage from the reference voltage and dividing by the transient large current; and

(4) comparing the internal resistance of the battery with a predetermined warning value thereof such that a warning can be displayed if the power is lower than a predetermined level.

It is a further object of the present invention to provide an apparatus for monitoring electric power of a battery, comprising a MCU (Microprocessor Control Unit) responsible for controlling the apparatus so as to sample a voltage of the battery to be measured in predetermined periods of time, calculate an internal resistance of the battery to be measured, and compare the internal resistance of the battery to be measured with a predetermined warning value of the internal resistance of the battery to be measured; first and second external loads both coupled in series with the battery to be measured so as to calculate the internal resistance of the battery to be measured; a voltage-sampling circuit responsible for sampling voltages of two terminals of the battery to be measured, the first power transistor, and the second power transistor with a transient large amount of current; a transient current control circuit including a first power transistor in series with the first external load, and a second power transistor in series with the second external load so as to be controlled by the MCU for being served as a switch of the apparatus and being responsible for controlling a magnitude of transient current of the first and second power transistors and sampling voltage of the battery to be measured; and an I/O responsible for issuing a warning if the comparison done by the MCU shows the internal resistance of the battery to be measured is equal to or larger than the predetermined warning value of the internal resistance of the battery to be measured.

The above and other objects, features and advantages of the present invention will become apparent from the following detailed description taken with the accompanying drawings.

## BRIEF DESCRIPTION OF THE DRAWINGS

FIG. 1 is a flow chart illustrating a process of monitoring the electric power, i.e. the condition, of battery according to the invention;

FIG. 2 is a detailed flow chart illustrating the FIG. 1 process;

FIG. 3 is an electrical block diagram of a first preferred embodiment of apparatus for monitoring the battery's electric power according to the invention;

FIG. 4 is an electrical block diagram of a second preferred embodiment of apparatus for monitoring the battery's electric power according to the invention;

FIG. 5 is an electrical block diagram of a third preferred embodiment of apparatus for monitoring the battery's electric power according to the invention;

FIG. 6 is an electrical block diagram of a fourth preferred embodiment of apparatus for monitoring the battery's electric power according to the invention;

FIG. 7 plots sampled voltage versus sampling time for voltage curves according to the invention;

FIG. 8 plots internal resistance of the battery versus discharge percentage for a discharge curve according to the invention; and

FIG. 9 is an equivalent circuit of the battery and a series external load according to the invention.

## DETAILED DESCRIPTION OF THE PREFERRED EMBODIMENTS

Referring to FIGS. 1 and 8, a process of monitoring the electric power of a battery (e.g., one installed in an automobile) according to the invention is illustrated.

In step 1, the resistance R of an external load is set, that is selected from values between 25uΩ to 5000mΩ optionally by means of using an amplifier based on battery type and an internal resistance of the battery to be measured.

In step 2, the predetermined value to which the internal resistance r of the battery will be compared is selected from the range of 0.001Ω to 1.5Ω based on the battery type. An appropriate setting depends on applications so as to provide a predetermined value, a warning range, or one of a plurality of predetermined warning values for multiple stages of warning before the end of discharging (see FIG. 8).

In step 3, a first power transistor Q1 or its related circuit is controlled to conduct as a first external load. Obtain a plurality of reference voltages thereof and store same.

In step 4, the reference voltages at two terminals of the battery and the external load are sampled while a transient large current is drawn by the first external load by controlling the first power transistor Q1 to conduct transiently for a plurality of times, that is intermittently, so as to obtain a plurality of an average of each group of first and second sampled reference voltages. A reference voltage curve is formed by connecting a plurality of the first and second sampled reference voltages together.

In step 5, a second power transistor Q2 or its related circuit is controlled to conduct as a second external load. Obtain a load voltage thereof and store same.

In step 6, the load voltages at two terminals of the battery and the external load are sampled while a transient large current is drawn by the second external load by controlling the second power transistor Q2 to conduct transiently for a plurality of times, that is intermittently, so as to obtain an average of each group of first and second sampled load voltages. A load voltage curve is formed by connecting a plurality of the first and second sampled load voltages together.

In step 7, remove the second external load (i.e., the transistor Q2).

In step 8, remove the first external load (i.e., the transistor Q1).

In step 9, a difference between average load voltage sampled at second times and average reference voltage sampled at second times is divided by the resistance of the external load (R) to obtain a current of the battery. And in turn, an internal resistance (r) of the battery to be measured is obtained by dividing a difference between average reference voltage sampled at first times and average load voltage sampled at first times by the current (I) of the battery. Next, the obtained internal resistance of the battery is compared with the predetermined value of internal resistance (r) of the battery so as to determine whether the former is in a predetermined warning range or not.

In step 10, an input and output (I/O) operation is performed in response to the comparison result in step 9. The I/O may be one of the followings, for example, such as a display, a keyboard input, a wireless operation, USB (Universal Serial Bus) connector, databus, CAN (Controller Area Network) bus, GPS (Global Positioning System), SMS (Simple Message Service), MMS (Multimedia Message Service), WAP (Wireless Application Protocol), net work or an access to the Internet.

Referring to FIGS. 2, 7 and 8, detailed method steps of the above process are illustrated.

In step 11, the process begins by setting an interrupt vector address as an initial address of a program.

In step 12, a register and I/O pins are initialized for setting an initial value of the register, the interrupt vector and timer are activated, and state and initial value of each I/O pin is defined.

In step 13, the resistance (R) of the external load is set as $25u\Omega$ to $5000m\Omega$ based on requirement of battery type and an internal resistance of the battery to be measured. The resistance R of the external load can be amplified.

In step 14, the predetermined value to which the internal resistance r of the battery will be compared is set as $0.001\Omega$ to $1.5\Omega$ based on the battery type. An appropriate setting value depends on applications so as to provide a predetermined warning value before the end of discharging (see FIG. 8).

In step 14a, a first power transistor Q1 or its related circuit served as a first external load is controlled to conduct so that a large amount of transient current is drawn. A reference voltage Vr thereof (see FIG. 7) is obtained.

In step 15, the reference voltage Vr is sampled for a plurality of times. The transient sampling time is set within 0.01 second. As shown in FIG. 7, providing a very large transient current by conducting the first power transistor Q1 or its related circuit between the two terminals of the battery, the reference voltage $V_{r1}$ (as shown in FIG. 7) between two terminals of the battery to be measured is sampled for K1 times, where $K1 \geqq 1$, the reference voltage $V_{r2}$ between two terminals of the external load is sampled for L1 times, where $L1 \geqq 1$, and average value of voltages $V_{r1}$ and $V_{r2}$ are therefore calculated and stored. The large transient current is preferably in the range of 1 A to 500A.

In step 15a, a second power transistor Q2 or its related circuit served as a second external load is operated to conduct so that a large amount of transient current is drawn. A load voltage thereof $V_L$ (see FIG. 7) is obtained.

In step 15b, the load voltage $V_L$ is sampled in a plurality of times. The transient sampling time is set within 0.01 second. As shown in FIG. 7, providing a transient large current by conducting the second power transistor Q2 or its related circuit between the two terminals of the battery, the load voltage $V_{L1}$ between two terminals of the battery to be measured is sampled for K2 times, where $K2 \geqq 1$, the load voltage $V_{L2}$ between two terminals of the load is sampled for L2 times, where $L2 \geqq 1$, and the average value of voltages $V_{L1}$ and $V_{L2}$ are calculated and stored. The large transient current is preferably in the range of 1 A to 500A.

More specifically, "large transient current" as used herein is typically a current equal to between 1C and 5C, where "C", as is usual in the industry, is the number of ampere-hours (a-h) that can be provided by a given battery in 20 hours. For example, a battery rated at 34 a-h can deliver 34 a-h if discharged over a period of 20 hours, so 1C for this battery is 34 amperes.

In step 15c, the second external load having second load resistance (i.e., second power transistor Q2 or its related circuit) is removed. The second power transistor Q2 or its related circuit is cut off with no transient large current output.

In step 15d, the first external load having first load resistance (i.e., first power transistor Q1 or its related circuit) is removed. The first power transistor Q1 or its related circuit is cut off with no transient large current output.

In step 15e, it is determined whether the number of samples is equal to N, where $N \geqq 1$. If yes, the process goes to step 16. Otherwise, the process loops back to step 15.

In step 16, the average of the internal resistance (r) of the battery to be measured is calculated by referring to FIG. 9 as below. Current I of the battery to be measured is obtained by the following equation.

$$ I = \frac{V_{L2} - V_{r2}}{R} = \frac{\triangle V_L}{R} \qquad EQ\ 1 $$

Further, the internal resistance (r) of the battery to be measured is calculated by the following equation.

$$ r = \frac{V_{r1} - V_{L1}}{I} = \frac{\triangle V_r}{I} \qquad EQ\ 2 $$

More specifically, in order to fully understand the above two equations, let us assume the value of the external load R=1 m$\Omega$, as viewed from FIG. 7, the curve VB represents the voltage across two terminals of the battery to be measured, and the curve $V_R$ represents the voltage across two terminals of the external load R. It is assumed that in the FIG. 7, the values are
$V_0$=12.70 volt, Vr1=12.30 volt, $V_{L1}$=11.55 volt, Vg=0 volt, Vr2=0.25 volt, $V_{L2}$=0.4 volt. Thus, from the EQ 1, we obtain the transient large current I = $\Delta V_L$ / R,
I = (0.4-0.25)/1x0.001=0.15/0.001=150 (amperes); and
From the EQ 2, we obtain the value of internal resistance (r) of the battery as
r =$\Delta V_r$/ I = (12.30-11.55)/ 150=0.005 ($\Omega$) =5 (m$\Omega$).
In step 17, the internal resistance (r) of the battery obtained in step 16 is compared with the predetermined value of internal resistance of the battery selected in step 14 so as to determine whether the former is in a warning range or not.
In step 18, an I/O (e.g., a keyboard input, a wireless operation, net work, USB (Universal Serial Bus) connector, databus, CAN (Controller Area Network) bus, GPS (Global Positioning System), SMS (Simple Message Service), MMS (Multimedia Message Service), WAP (Wireless Application Protocol) or an access to the Internet is performed in response to reaching the value in step 17.
In step 18a, a new internal resistance $r_{new}$ via I/O is setting for a next sampling cycle. If yes, the process loops back to step 14a. Otherwise, the process goes to step 19.
In step 19, timer begins to count time.
In step 20, it is determined whether time is equal to time T2 of a next sampling. If yes, the process loops back to step 14a for a next sampling. Otherwise, the process loops back to step 19. That is, the condition of the battery is evaluated from time to time, so as to reduce the total current drawn.
The voltage sampling process from step 15 to step 15e takes one period of time. This is depicted in the graph of FIG. 7 of sampled voltage versus sampling time for voltage curves according to the invention. Voltage curve $V_{r1}$ represents a reference voltage taken at two terminals of the battery 7 to be measured and voltage curve $V_{r2}$ represents a reference voltage taken at two terminals of the first external load (see FIGS. 3 and 4) when a transient large current is generated by the conducted the first power transistor Q1 due to voltage change from no load state to first external load state. Voltage curve $V_{L1}$ represents the first load voltages taken at two terminals of the battery 7 to be measured and voltage curve $V_{L2}$ represents the first load voltages taken at two terminals of the second external load (see FIGS. 3 and 4) when a transient large current is generated by the conducted the second power transistor Q2 due to voltage change from the first external load state to the second external load state. In the graph of FIG. 7, reference voltages $V_{r1}$ and $V_{r2}$ are obtained in step 15 and load voltages $V_{L1}$ and $V_{L2}$ are obtained in step 15b.
Referring to the voltage curves in FIG. 7 again, the sampling with respect to respective voltage curves can be best understood. Curves $V_{r1}$ and $V_{r2}$ are the reference voltage curves by conducting the first power transistor Q1 and curves $V_{L1}$ and $V_{L2}$ are the load voltage curves of the second external load (i.e., second power transistor Q2). In detail, voltage curve $V_{r1}$ represents that a reference voltage of the first power transistor Q1 has been sampled for K1 times. Voltage curve $V_{L1}$ represents that a load voltage of the second power transistor Q2 has been operated to conduct for K2 times. Likewise, Voltage curve $V_{r2}$ represents that a reference voltage of the first power transistor Q1 has been operated to conducted for L1 times. Voltage curve $V_{L2}$ represents that a load voltage of the second power transistor Q2 has been operated to conducted for L2 times. $\Delta V_r$ is a difference between $V_{r1}$ and $V_{L1}$. $\Delta V_L$ is a difference between $V_{L2}$ and $V_{r2}$.
Referring to FIG. 3, there is shown an electrical block diagram of a first preferred embodiment of apparatus 60 for monitoring the battery's electric power according to the invention. It illustrates a Kelvin connection formed by connections 64A and 64B, 65A and 65B, to battery 7. With such a Kelvin connection, two couplings are provided to the positive and negative terminals of battery 7. This allows the one pair of the electrical connections 65A and 65B at two terminals of the battery to draw a large amount of transient current while the other pair of connections 64A and 64B can be used to sample accurate voltage reading values. As the resistance value between connections A/D and 65A, 65B is very little and substantially no current is flowing through the connections A/D and 65A, 65B, there will be little voltage drop through the electrical connection between connections A/D and 65A, 65B, thereby providing more accurate voltage measurements.

The apparatus 60 comprises a MCU (Microprocessor Control Unit) 62, a voltage-stabilizing circuit 61 (optionally provided depending on the actual applications), an external loads 63 and 66, a voltage-sampling circuit 64, a transient current control circuit 65, and an I/O 66. Each component will be described in detailed below.

The MCU 62 is responsible for controlling the apparatus 60 so as to send signals to the battery 7 for sampling its voltage in predetermined periods of time, calculate the internal resistance r of the battery 7, and compare the warning value of internal resistance r with a predetermined value thereof for warning if necessary. The voltage-stabilizing circuit 61 is optionally used for providing a stable voltage to the apparatus 60 during operating periods, that is, if the apparatus 60 used a stable DC cell or battery, then, the voltage-stabilizing circuit 61 can be omitted accordingly. The external loads 63 and 66 have a predetermined resistance. In a preferred embodiment of the invention, the external loads 63 and 66 are a combination of parallel resistors R1 and R2 (or their related circuit). The resistance R1 of the first external load 63 (i.e., the first power transistor Q1 or its related circuit) is set as $25u\Omega$ to $5000m\Omega$ and is provided directly in series with the battery and the resistance R2 of the second external load 66 (i.e., the second power transistor Q2 or its related circuit) is set as $25u\Omega$ to $5000m\Omega$ and is also provided directly in series with the battery so as to calculate the internal resistance r of the battery. Note that the external loads 63 and 66 have a substantially very low resistance so as to be able to sample the voltage of the battery 7 in a very s transient sampling time with a very larger amount of transient current. For example, sampling voltage by optionally applying a large amount of transient current 1A to 500A is required (i.e., to sample voltage) within 0.01 second. Also note that the external loads 63 and 66 are implemented as a resistor such as Manganin or formed of any of a number of other alloys known to the art. Alternatively, the external loads 63 and 66 can be implemented as a switching element having a resistance, for example, the internal resistance of the first and second power transistors Q1, Q2. It means that the internal resistance of the first and second power transistors Q1, Q2 in the transient current control circuit 65 can be used as the external loads so that the external load 63, 66 (i.e., resistors R1 and R2) in this embodiment can be omitted from the circuit 65A-65B of FIG. 3. Furthermore, the external loads 63, 66 can also be implemented by a portion of conductor extended between two terminals of the battery, such as a portion of conductor between two terminals 63E and 63F (without R1), two terminals 66E and 66F (without R2) or the conductor between A/D i.e. terminals 63A-63E, 63C-63F, 66A-66E, 66C-66F. Note that in a preferred embodiment of the invention the voltage-sampling circuit 64 is responsible for sampling voltage across two terminals 64A, 64B. As shown in FIG. 3, one terminal 64A is electrically interconnected to a positive terminal of A/D pin of MCU 62 and a positive terminal of the battery 7 and the other terminal 64B is electrically interconnected to a negative terminal of A/D pin of MCU 62 and a negative terminal of the battery 7. As an end, a correct voltage can be sampled. That is, signal conductors connected to terminals 64A, 64B allow measurement of the voltage across the battery separately from the voltage across the load R. The transient current control circuit 65 is controlled by the MCU 62. In a preferred embodiment of the invention, the transient current control circuit 65 is implemented as the first power transistor Q1 and the second power transistor Q2 both connected in parallel to the battery. The transient current control circuit 65 serves as a switch of the apparatus and is responsible for controlling the magnitude of transient large current of the load. That is, a regulated transient large current is drawn from the battery 7 for sampling voltage thereof during voltage sampling periods. The I/O 67 is responsible for indicating a warning by means of a keyboard input, a wireless operation, net work, USB (Universal Serial Bus) connector, databus, CAN (Controller Area Network) bus, GPS (Global Positioning System), SMS (Simple Message Service), MMS (Multimedia Message Service), WAP (Wireless Application Protocol) or an access to the Internet if the comparison of the internal resistance of the battery with the set warning value of internal resistance of the battery by the MCU 62 shows that a warning value has been reached.

In brief, after connecting the apparatus 60 of monitoring the battery's electric power according to the invention to the battery 7, optionally, the voltage-stabilizing circuit 61 provides required voltage to the apparatus including the MCU 62 during operating periods. The MCU 62 then performs above operations based on the method of monitoring electric power by comparing internal resistance of its battery with that of external load. First, the voltage-sampling circuit 64 samples voltage of the battery 7 when the external load is temporarily removed. After adding the first external load 63 (i.e., power transistors Q1) to the apparatus, the transistor Q1 of the transient current control circuit 65 is controlled to conduct to provide a transient large amount of current. Next, the voltage-sampling circuit 64 samples reference voltages Vr1 across two terminals of the battery 7 and $V_{r2}$ across two terminals of the external loads 63, respectively. Further, adding the second external load 66 (i.e., power transistor Q2) to the apparatus, the second power transistor Q2 of the transient current control circuit 65 conducts to provide a transient large amount of current. Next, the voltage-sampling circuit 64 samples load voltage $V_{L1}$ across two terminals of the battery 7 and $V_{L2}$ across two terminals of the external loads 66. After sampling reference voltages and load voltages for N times in a predetermined period of time, the MCU 62 removes the second load Q2 and then the first load Q1. The MCU 62 then calculates the internal resistance r of the battery 7 by means of the sampled reference and load voltages and two equations as described above in step 16 of FIG. 2. Furthermore, the obtained internal resistance r of the battery 7 is compared with the predetermined value of internal resistance of the battery. As an end, a warning is issued through the I/O 67 if necessary.

Referring to FIG. 4, there is shown an electrical block diagram of a second preferred embodiment of apparatus 60 of monitoring the battery's electric power according to the invention. The second preferred embodiment substantially has same structure as the first preferred embodiment. The characteristics of the second preferred embodiment are detailed below. The transient current control circuit 65 of the apparatus 60 is implemented as two parallel transistors Q1 and Q2. The transistors Q1 and Q2 are sequentially conducted so as to obtain a lowest voltage value of two terminals.

Referring to FIG. 5, there is shown an electrical block diagram of a third preferred embodiment of apparatus 60 of monitoring the battery's electric power according to the invention. The third preferred embodiment substantially has same structure as the second preferred embodiment. The characteristics of the third preferred embodiment are detailed below. The external load 630 has a very low resistance. An amplifier 68 is optionally interconnected the external load 630 and the MCU 62. Preferably, the external load 63 has a resistance lower than 5000 uΩ.

Referring to FIG. 6, there is shown an electrical block diagram of a fourth preferred embodiment of apparatus 60 of monitoring the battery's electric power according to the invention. The fourth preferred embodiment substantially has same structure as the second preferred embodiment. The characteristics of the fourth preferred embodiment are detailed below. The external load is implemented as a shunt unit S labeled as 63S. In the preferred embodiment, a shunt load of the single battery to be measured is implemented as a shunt circuit for obtaining the same effect as any of the above embodiments.

While the invention herein disclosed has been described by means of specific embodiments, numerous modifications and variations could be made thereto by those skilled in the art without departing from the scope and spirit of the invention set forth in the claims.

**Claims**

1. A method of monitoring the electric power of a battery by measuring an internal resistance of the battery, comprising the steps of:

(1) coupling a first power transistor at two terminals of the battery as a first external load with a transient large current at a very transient sampling time to obtain a reference voltage;
(2) coupling second power transistor at two terminals of the battery as second external load with a transient large current at a very transient sampling time to obtain a load voltage;
(3) calculating the internal resistance of the battery by subtracting the load voltage from the reference voltage and dividing by the transient large current; and
(4) comparing the internal resistance of the battery with a predetermined warning value thereof such that a warning can be displayed if the power is lower than a predetermined level.

2. The method of claim 1, further comprising the steps of:

(1) choosing an external load, the resistance R of which is selected in accordance with the type of the battery to be evaluated,
(2) selecting a value for the nominal internal resistance of the battery in accordance with its type;
(3) choosing a first power transistor or its related circuit as a first external load to obtain a reference voltage Vr;
(4) providing the first power transistor controlled for connecting the first external load across two terminals of the battery and repetitively controlling the first power transistor to conduct so that a large transient current is drawn from the battery by the first external load at a very transient sampling time and sampling a first reference voltage $V_{r1}$ between two terminals of the battery and sampling a second reference voltage $V_{r2}$ between two terminals of the external load, respectively for a plurality of times, and calculating and storing average values of the voltages $V_{r1}$ and $V_{r2}$;
(5) choosing a second power transistor or its related circuit as a second external load to obtain a load voltage $V_L$;
(6) providing the second power transistor controlled for connecting the second external load across two terminals of the battery and repetitively controlling the second power transistor to conduct so that a large transient current is drawn from the battery by the second external load at a very transient sampling time and sampling a first load voltage $V_{L1}$ between two terminals of the battery and sampling a second load voltage $V_{L2}$ between two terminals of the external load, respectively for a plurality of times, and calculating and storing average values of the voltages $V_{L1}$ and $V_{L2}$;

(7) removing the second external loads for stopping supplying the transient large current;

(8) removing the first external loads for stopping supplying the transient large current;

(9) determining the large transient current I drawn by the load by subtracting Vr2 from $V_{L2}$ and dividing by the resistance R;

(10) calculating the internal resistance r of the battery by subtracting $V_{L1}$ from Vr1 and dividing by the transient large current I;

(11) comparing the obtained internal resistance of the battery to be measured with a predetermined warning value of the internal resistance of the battery to be measured so as to determine whether the former is equal to or larger than the predetermined warning value or not; and

(12) issuing a warning through an input and output (I/O) if the determination in step (11) is affirmative.

**3.** The method of claim 1 or 2, wherein the predetermined warning value of the internal resistance of the battery to be measured is 0.001Ω to 1.5Ω.

**4.** The method of any one of the claims 1 to 3, wherein the resistance of the external load is in a range from 25μΩ to 5000mΩ.

**5.** The method of any one of the claims 1 to 4, wherein the resistance of the external load is optionally coupled to an amplifier.

**6.** The method of any one of the claims 1 to 5, wherein the external load is provided as an internal resistor of either power transistor.

**7.** The method of any one of the claims 2 to 6, wherein the transient large current is in a range from 1 A to 500A.

**8.** The method of any one of the claims 2 to 7, wherein the transient sampling time is less than 0.01 second.

**9.** The method of any one of the claims 2 to 8, wherein the I/O is one of a display, a keyboard input, a wireless operation, net work, USB (Universal Serial Bus) connector, databus, CAN (Controller Area Network) bus, GPS (Global Positioning System), SMS (Simple Message Service), MMS (Multimedia Message Service), WAP (Wireless Application Protocol) or an access to the Internet.

**10.** The method of any one of the claims 1 to 9, further comprising the steps of:

(1) beginning by setting an interrupt vector address as an initial address of a program;

(2) initializing a register and I/O pins for setting an initial value of the register, activating the interrupt vector and a timer, and defining a state and an initial value of each I/O pin;

(3) choosing an external load, a resistance R of which is based on a type of the battery to be evaluated;

(4) selecting a value for a nominal internal resistance of the battery in accordance with its type;

(5) choosing a first power transistors as first external load and conducting the first power transistors for providing the transient large current;

(6) transiently sampling between two terminals of the battery with a transient large current supplied from the conducted first power transistor for K1 times, where K1≧1 and for L1 times, where L1≧1, respectively so as to obtain an average of each group of a first sampled reference voltage $V_{r1}$ between two terminals of the battery and a second sampled reference voltage $V_{r2}$ between two terminals of the external load;

(7) choosing a second power transistor as second external loads and conducting the second power transistors for providing the transient large current;

(8) transiently sampling at two terminals of the battery with a transient large current supplied from the conducted second power transistor for K2 times, where K2≧1 and for L2 times, where L2≧1, respectively so as to obtain an average of each group of a first sampled load voltage $V_{L1}$ between two terminals of the battery and a second sampled load voltage $V_{L2}$ between two terminals of the external load;

(9) removing the second external load for stopping supplying the transient large current;

(10) removing the first external load for stopping supplying the transient large current;

(11) determining whether the number of samplings is equal to N or not, where N≧ 1 and if the determination is negative then loops back to step (6);

(12) determining the large transient current I drawn by the load by subtracting Vr2 from $V_{L2}$ and dividing by R;

(13) calculating the internal resistance (r) of the battery by subtracting $V_{L1}$ from $V_{r1}$ and dividing by the transient large current I of the battery; and

(14) comparing the obtained internal resistance (r) of the battery to be measured with the selected nominal value thereof to determine the condition of the battery to be measured.

11. The method of claim 10, wherein the transient sampling time is less than 0.01 second.

12. The method of claim 10 or 11, wherein the I/O is one of a display, a keyboard input, a wireless operation, net work, USB (Universal Serial Bus) connector, databus, CAN (Controller Area Network) bus, GPS (Global Positioning System), SMS (Simple Message Service), MMS (Multimedia Message Service), WAP (Wireless Application Protocol) or an access to the Internet.

13. An apparatus for monitoring the condition of a battery by coupling a first power transistor as a first external load to obtain a first sampled reference voltage and a second sampled reference voltage and coupling a second power transistor as a second external load to obtain a first sampled load voltage and a second sampled load voltage, comprising:

a controller for controlling the apparatus so as to sample a voltage across the battery in predetermined periods of time responsive to imposition of a known external load chosen responsive to the type of the battery, calculate an internal resistance of the battery to be measured, and compare the internal resistance of the battery to be measured with a predetermined warning value therefor;
an external load being a load element and having a predetermined resistance, the external load comprising the first and second external loads both coupled in series with the battery, respectively;
a voltage-sampling circuit responsible for sampling voltages across two terminals of the battery;
a transient current control circuit including the first power transistor and the second power transistor, when the transient current control circuit is connected across two terminals of the battery so as to be controlled by the controller for being served as a switch of the apparatus so that a large transient current of the first and second power transistors is drawn by the first and second external loads from the battery and sampling the above voltages of the battery at a very transient sampling time for a plurality of times; and dividing a difference between the second sampled load voltage and the second sampled reference voltage by the resistance of the external load to obtain a large transient current of the battery; and dividing a difference between the average first sampled reference voltage and the average first sampled load voltage by the large transient current of the battery so as to obtain the internal resistance of the battery to be measured; and
an input/output (I/O) means responsive to the controller for issuing a warning responsive to comparison of the calculated value of the internal resistance of the battery with the predetermined value thereof.

14. The apparatus of claim 13, wherein the apparatus further comprises an amplifier optionally coupled to the parallel first and second transistors taken as load.

15. The apparatus of claim 13 or 14, wherein the load element is an internal resistance of the power transistor.

16. The apparatus of any one of the claims 13 to 15, wherein the transient current control circuit comprises two or more parallel power transistors.

17. The apparatus of any one of the claims 13 to 16, wherein the resistance of each of the first and second power transistors is in a range from $25\mu\Omega$ to $5000m\Omega$.

18. The apparatus of any one of the claims 13 to 17 wherein the predetermined warning value of the internal resistance of the battery to be measured is $0.001\Omega$ to $1.5\Omega$.

19. The apparatus of any one of the claims 13 to 18, wherein the transient large current is in a range from 1 A to 500A.

20. The apparatus of any one of the claims 13 to 19, wherein the voltage sampling time is less than 0.01 second.

21. The apparatus of any one of the claims 13 to 20, wherein the I/O is one of a display, a keyboard input, a wireless operation, net work, USB (Universal Serial Bus) connector, databus, CAN (Controller Area Network) bus, GPS (Global Positioning System), SMS (Simple Message Service), MMS (Multimedia Message Service), WAP (Wireless Application Protocol) or an access to the Internet.

**22.** The apparatus of any one of the claims 13 to 21, wherein a value of the internal resistance of the battery is measured through Kelvin connections.

set resistance R of
external load — 1

set internal resistance r
of battery — 2

conduct first external load Q1
or its related circuit and obtain
a reference voltage and store same — 3

sampling transiently — 4

conduct second external load Q2
or its related circuit and obtain
a load voltage and store same — 5

sampling transiently — 6

remove the second external load Q2 — 7

remove the first external load Q1 — 8

calculate and compare resistance r — 9

I / O — 10

**FIG1**

begin

initialization

set resistance R of external load

set internal resistance $r$ of battery

conduct first external load Q1 or its related circuit to obtain a reference voltage Vr

sampling refernce voltages Vr1 for K1 times and Vr2 for L1 times, store average refernce voltage, where $K1 \geqq 1$ and $L1 \geqq 1$

conduct second external load Q2 or its related circuit to obtain a load voltage VL

sampling load voltages VL1 for K2 times and VL2 for L2 times store average load voltage, where $K2 \geqq 1$ and $L2 \geqq 1$

remove second load Q2

remove first load Q1

compare resistance

I / O

NO

the number of samplings $N \geqq 1$?

YES

calculate an average of internal resistance of battery

$$I = \frac{VL2 - Vr2}{R} = \frac{\triangle VL}{R}$$

$$r = \frac{Vr1 - VL1}{I} = \frac{\triangle Vr}{I}$$

set new internal resistance $r_{new}$ Via I/O for next sampling cycle

YES

NO

count time

NO

$time \geqq T2$?

YES

**FIG2**

**FIG3**

**FIG4**

**FIG5**

**FIG6**

**FIG7**

internal resistance of battery (✳)

5.0
3.0
2.0
1.0
0.5
0.3
0.2
0.10
0.05
0.03
0.02
0.010
0.005

0    20    40    60    80    100   120

discharged (%)          ▮→ over-discharged

(fully charged)

# FIG8

$V_E$

$r$    $V_r$

$R$    $V_R$

$V_R$

$V_E$

$V_r$

# FIG9

**European Patent Office**

**EUROPEAN SEARCH REPORT**

Application Number

EP 07 00 3428

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2004/222797 A1 (PALANISAMY ET AL:) 11 November 2004 (2004-11-11) * paragraphs [0624], [0037] - [0039]; figure 1 * | 1,13 | INV. G01R31/36 |
| X | US 2006/001429 A1 (HUANG) 5 January 2006 (2006-01-05) | 13-22 | |
| A | * paragraphs [0034], [0047], [0048], [0050]; claims 28-35,40; figures 4-7 * | 2-12 | |
| A | US 5 352 968 A (RENI ET AL) 4 October 1994 (1994-10-04) * column 7, line 22 - column 8, line 23; figures 5-7 * | 1,13 | |
| A | JP 63 012981 A (MITSUBISHI ELECTRIC CORP) 20 January 1988 (1988-01-20) * abstract * | 1,13 | |
| A | GB 2 397 656 A (INTELLIGENT BATTERY TECHNOLOGY) 28 July 2004 (2004-07-28) * abstract; figures 3-5 * | 1,13 | TECHNICAL FIELDS SEARCHED (IPC) |
| P,X | EP 1 632 782 A (DELPHI TECHNOLOGIES) 8 March 2006 (2006-03-08) | 1 | G01R |
| P,A | * paragraphs [0028], [0030], [0031]; figures 2-4 * | 2-12 | |

The present search report has been drawn up for all claims

| Place of search | Date of completion of the search | Examiner |
|---|---|---|
| Munich | 16 May 2007 | Iwansson, Kaj |

## ANNEX TO THE EUROPEAN SEARCH REPORT
## ON EUROPEAN PATENT APPLICATION NO.

EP 07 00 3428

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2007

| Patent document cited in search report | | Publication date | Patent family member(s) | | Publication date |
|---|---|---|---|---|---|
| US 2004222797 | A1 | 11-11-2004 | EP 1620741 A1<br>KR 20060012280 A<br>WO 2004099804 A1 | | 01-02-2006<br>07-02-2006<br>18-11-2004 |
| US 2006001429 | A1 | 05-01-2006 | NONE | | |
| US 5352968 | A | 04-10-1994 | NONE | | |
| JP 63012981 | A | 20-01-1988 | NONE | | |
| GB 2397656 | A | 28-07-2004 | AU 2004205978 A1<br>CA 2513877 A1<br>EP 1588439 A2<br>WO 2004066413 A2<br>US 2007001680 A1 | | 05-08-2004<br>05-08-2004<br>26-10-2005<br>05-08-2004<br>04-01-2007 |
| EP 1632782 | A | 08-03-2006 | NONE | | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6704629 B
- US 6791464 B
- US 20060001429 A1
- WO 6072300 A, Tsuji
- WO 5027294 A, Fakruddin
- WO 6704629 A, Huang
- WO 6201373 A, Arai
- WO 5381096 A, Hirzel
- WO 6531875 A, Satake
- US 20030067221 A1, Disser
- WO 5828218 A, Yokoo
- WO 5900734 A, Munson
- WO 6097193 A, Bramwell
- WO 6249106 A, Turner
- WO 3852732 A, Yorksie
- WO 4193026 A, Finger
- WO 5130699 A, Reher
- WO 5193067 A, Sato
- WO 5764469 A, Slepian
- WO 6791464 A, Huang
- WO 6424157 A, Gollomp